Europäisches Patentamt

European Patent Office

Office européen des brevets

(19)

(11) Numéro de publication : **0 425 336 B1**

(12) **FASCICULE DE BREVET EUROPEEN**

(45) Date de publication du fascicule du brevet :
29.06.94 Bulletin 94/26

(51) Int. Cl.⁵ : **C23C 14/06**

(21) Numéro de dépôt : **90402840.4**

(22) Date de dépôt : **11.10.90**

(54) **Revêtement de substrat, pour conférer à celui-ci de bonnes propriétés tribologiques, en alliage chrome-azote, et procédé d'obtention.**

(30) Priorité : **20.10.89 FR 8913739**

(43) Date de publication de la demande :
**02.05.91 Bulletin 91/18**

(45) Mention de la délivrance du brevet :
**29.06.94 Bulletin 94/26**

(84) Etats contractants désignés :
**BE CH DE ES GB IT LI LU NL SE**

(56) Documents cités :
**LE VIDE, LES COUCHES MINCES, vol. 41, no. 230, janvier-février 1986, pages 77-83, Paris, FR; J. DANROC et al.: "Revetements de chrome et molybdene durselabores par pulverisation cathodique magnetron"**
**CONFERENCE ON ION ASSISTED SUFRACE TREATMENTS, TECHNIQUES AND PROCESSES, Coventry, 14-16 septembre 1982, pages 16.1-16.6; R. GILLET et al.: "Hard chrome coatings deposited by physical vapour deposition"**
**PRAKTISCHE METALLOGRAPHIE, vol. 26, no. 2, février 1989, page 69; D. DUBIEL: "Characterization of sputter deposited chromium nitride coatings"**

(56) Documents cités :
**LE VIDE, LES COUCHES MINCES, vol. 41, no. 230, janvier-février 1986, pages 71-75, Paris, FR; G. GHOLVY et al.: "Obtention et caracterisation de depôtsréalisés dans le ternaire Cr-C-N par PVD"**
**THIN SOLID FILMS, vol. 126, nos. 1/2, avril 1985, pages 61-67, Elsevier Sequoia, Lausanne, CH; A. AUBERT et al.: "Hard chrome and molybdenum coatingsproduced by physical vapour deposition"**
**THIN SOLID FILMS, vol. 185, no. 2, mars 1990, pages 219-230, Lausanne, CH; D. WANG et al.: "The morphology and orientation of Cr-N films deposited byreactive ion plating"**

(73) Titulaire : **CENTRE STEPHANOIS DE RECHERCHES MECANIQUES HYDROMECANIQUE ET FROTTEMENT**
**Société dite:**
**Zone Industrielle Sud**
**Rue Benoît Fourneyron**
**F-42160 Andrezieux Boutheon (FR)**

(72) Inventeur : **Terrat, Jean-Paul**
**10 rue Etienne Boisson**
**F-42000 Saint-Etienne (FR)**
Inventeur : **Fort, Pascal**
**Avenue de Champ Rouget**
**F-12200 Villefranche de Rouergue (FR)**

(74) Mandataire : **CABINET BONNET-THIRION**
**95 Boulevard Beaumarchais**
**F-75003 Paris (FR)**

## Description

L'invention se rapporte à un revêtement de substrat, pour conférer à celui-ci de bonnes propriétés tribologiques, constitué d'un alliage de chrome-azote hors équilibre thermodynamique. L'invention se rapporte également à un procédé d'obtention d'un tel revêtement.

Par propriétés tribologiques d'une surface ou revêtement, on entend les propriétés qui déterminent le comportement de cette surface en frottement, au cours du temps. Les paramètres qui expriment ce comportement sont essentiellement la vitesse d'usure en frottement, et le coefficient de frottement.

Le frottement dont il est question ici est un frottement vrai entre deux surfaces, et non un frottement lubrifié où un film de lubrifiant s'interpose entre les deux surfaces solides, et où le mouvement relatif se produit essentiellement entre les couches de lubrifiant dans le film.

Notamment lorsque les conditions de frottement sont dures, avec une charge spécifique élevée, la résistance à l'usure implique une dureté élevée de la surface frottante. En contrepartie, l'augmentation de dureté d'un revêtement frottant s'accompagne fréquemment d'un accroissement de fragilité, avec un risque d'usure précoce par érosion.

Il y a certes une corrélation entre vitesse d'usure et coefficient de frottement, car une augmentation du coefficient de frottement entraîne, toutes choses égales par ailleurs, un accroissement d'énergie dégradée, et la vitesse d'usure est en relation directe avec cette énergie dégradée.

Dans de nombreuses applications, l'énergie dégradée par frottement ne représente qu'une part mineure de l'énergie mise en jeu ; il est alors plus important de rechercher globalement une réduction de la vitesse d'usure, qui dépend de la dureté, de la fragilité et du coefficient de frottement conjointement, que la réduction du seul coefficient de frottement.

Aussi, dans ce qui suit, par bonnes propriétés tribologiques, on entendra essentiellement une bonne résistance à l'usure, incluant l'usure par érosion de revêtements fragiles. L'essai type sera une mesure de la vitesse d'usure, ou d'enlèvement de matière sur un revetement plan, au contact d'une bague en acier rapide chargée à 20 da N et glissant à une vitesse de 0,55 m/s sur le revêtement plan, dans l'eau.

Les documents, apparentés entre eux, FR-A-2 512 070 et EP-A-0 074 322, décrivent des alliages à bonnes propriétés tribologiques, comprenant du chrome et un élément alliant, carbone ou azote, où cet élément alliant est en solution d'insertion métastable dans le chrome avec des teneurs comprises entre un minimum correspondant à la saturation de la solution solide de l'élément alliant dans le chrome en équilibre thermodynamique, et un maximum définissant une saturation de la solution d'insertion.

Dans le cadre de la présente invention, on ne considère que le système chrome-azote. Dans ce système, on exprimera la teneur en azote par le nombre d'atomes d'azote pour 100 atomes de l'alliage, chrome et azote.

On rappelle que, sur le diagramme d'équilibre thermodynamique du système chrome-azote, dans le sens des teneurs croissantes en azote, on trouve une région de solution solide de 0 à 0,15 atomes d'azote pour cent d'alliage, puis un nitrure $Cr_2N$ à 33,3 atomes d'azote pour cent, puis un nitrure CrN, à 50 atomes d'azote. Le nitrure $Cr_2N$ présente une structure cristalline hexagonale, et le nitrure CrN une structure cubique de type NaCl. Ce dernier nitrure CrN présente tous les caractères d'une céramique. Par ailleurs, il est courant d'obtenir des alliages chrome-azote biphases, avec une phase de chrome cubique et une phase de nitrure $Cr_2N$ hexagonal.

Les documents de l'état de la technique précités, et notamment EP-A-0 074 322, font état d'une saturation des solutions d'insertion métastables d'azote dans le chrome pour 3,5 % en poids d'azote, ce qui correspond sensiblement à 12 atomes pour cent d'azote. Ces documents enseignent que les solutions d'insertion présentent une dureté très supérieure à celle du chrome (par exemple jusqu'à 2 200 Vickers contre 600 pour le chrome), et que pour des teneurs en éléments alliants supérieures à la saturation de la solution d'insertion, la composition des alliages étaient conformes à ce que l'on pouvait prévoir à partir des diagrammes d'équilibre thermodynamique.

Ces solutions d'insertion sont obtenues par pulvérisation cathodique rapide d'une cathode de chrome sur un substrat, dans une atmosphère à pression réduite d'un gaz rare contenant l'élément alliant à l'état combiné dissociable ou à l'état libre.

On constate en outre que les solutions d'insertion métastables provoquent des déformations de la maille cristalline cubique du chrome, qui seraient responsables de l'accroissement de dureté.

La Demanderesse a découvert que, contrairement à ce que l'on croyait d'après l'état de la technique, on pouvait, dans le système chrome-azote, obtenir des alliages métastables comportant plus d'azote que les solutions d'insertion évoquées ci-dessus, qui présentent des propriétés tribologiques supérieures à celles des solutions d'insertion, avec une vitesse d'usure inférieure, une absence de fragilité, et un coefficient de frottement relativement bas.

Aussi l'invention propose un revêtement de substrat, pour conférer à celui-ci de bonnes propriétés tribologiques, constitué d'un alliage de chrome et d'azote hors équilibre thermodynamique, caractérisé en ce que l'alliage contient, pour 100 atomes, de 87 à 68 atomes de chrome et de 13 à 32 atomes d'azote, et qu'il est constitué de deux phases, une phase de chrome microcristallin cubique contenant de l'azote inclus et une phase d'un nitrure de chrome quadratique à teneur en azote en défaut stoechiométrique par rapport au nitrure $Cr_2N$.

L'alliage biphase qui présente ces caractéristiques accuse une grande dureté (environ 2 000 Knoop) ; par rapport aux alliages connus chrome-azote de dureté comparable, il présente des avantages importants:

- sa vitesse d'usure est jusqu'à trois fois plus faible que celle des solutions d'insertion d'azote dans le chrome, au voisinage de la saturation ;
- sa vitesse d'usure est sensiblement la même que celle des nitrures CrN et $Cr_2N$, ainsi que des composés biphases constitués de chrome et de nitrure $Cr_2N$, mais il est considérablement moins fragile. Il ne présente pas d'écaillages au frottement, et possède donc une durée de vie bien supérieure à celle des composés à nitrures en équilibre thermodynamique ;
- en dépôt physique en phase vapeur, la finesse du grain n'est pas influencée par l'incidence du dépôt sur le substrat. Par contraste les dépôts classiques par le même processus ont des dimensions de grains très variables avec l'incidence. Cette non-dépendance de la finesse de grain et de l'incidence facilite l'exécution des dépôts sur des substrats de forme relativement compliquée, sans avoir à mettre au point des dispositions telles que tout élément de surface de substrat reçoive le pulvérisat sous des incidences équivalentes.

Les différences entre le nitrure $Cr_2N$ en équilibre thermodynamique et les nitrures métastables selon l'invention sont affirmées, tant par le contrôle des formes cristallines, par exemple par diffraction de rayons X, que par les propriétés nettement distinctes des alliages biphases, selon que la phase nitrure est quadratique ou hexagonale, alors même que leur composition globale est la même. Cependant il n'a pas été possible, à l'heure actuelle, de déterminer la composition chimique du nitrure quadratique. On comprendra que, notamment, le caractère métastable de ce nitrure rend très difficile une séparation des phases, la séparation risquant d'induire des réarrangements de composition. On notera d'ailleurs que la composition chimique du nitrure, dans la mesure où elle ne peut contribuer pratiquement ni à l'identification du nitrure, ni à son obtention, relèverait de la curiosité scientifique.

Il n'est pas même certain que les nitrures métastables quadratiques soient d'une espèce unique et définie. Les paramètres de maille cristalline doivent être compris entre 1,02 et 1,5, sans que, dans cette plage, on ait noté des valeurs préférées.

De préférence l'épaisseur de revetement est comprise entre 0,1 et 50 µm, et plus particulièrement entre 5 et 20 µm. Cette épaisseur est en relation avec les vitesses d'usure, le type d'application envisagé, et les tolérances admissibles. Vers les épaisseurs faibles, la grosseur des grains de l'alliage est à prendre en considération.

Sous un autre aspect, l'invention propose un procédé de revêtement d'un substrat électriquement conducteur, destiné à conférer à ce substrat de bonnes propriétés tribologiques, selon lequel on pulvérise du chrome en atmosphère réactive d'azote dans un gaz rare, confinée à basse pression dans une enceinte équipée d'un appareillage de pulvérisation dit magnétron avec, en combinaison avec un champ magnétique, un champ électrique établi entre le substrat anodique et une cible de chrome cathodique et engendrant un plasma, dans des conditions opératoires telles qu'il se forme un dépôt d'alliage de chrome et d'azote hors équilibre thermodynamique, procédé caractérisé en ce que l'on règle la pression partielle d'azote dans le gaz rare à une valeur choisie entre une pression minimale prédéterminée où l'alliage, monophase, est saturé en azote intersticiel, et une pression maximale prédéterminée où commence à se former du nitrure de chrome hexagonal $Cr_2N$, l'alliage contenant alors, pour 100 atomes, de 87 à 68 atomes de chrome et de 13 à 32 atomes d'azote, et présentant deux phases, une phase de chrome microcristallin cubique et une phase de nitrure de chrome quadratique, à teneur en azote en défaut stoechiométrique par rapport au nitrure de chrome hexagonal.

On comprend que la formation d'alliages métastables qui correspondent à des minimums relatifs d'énergie interne de cristallisation, séparés du minimum absolu correspondant à l'alliage en équilibre thermodynamique par des murs d'énergie infranchissables aux températures pratiquées, implique une vitesse de dépôt suffisante pour que les arrangements d'atome dans les cristaux soient figés dans leur configuration de dépôt.

Les conditions premières qui régissent ces configurations sont apparemment les flux respectifs d'atomes ionisés, chrome et azote, qui atteignent le substrat, et les niveaux d'énergie de ces atomes. Mais les lois sont très mal connues, et l'opérateur n'a pratiquement d'action qu'à travers les paramètres mesurables du dépôt, à savoir pression totale de l'atmosphère dans l'enceinte, pression partielle d'azote, chute de potentiel dans la décharge, intensité de décharge et, dans une certaine mesure, trajectoires des ions. Or ces paramètres sont partiellement interdépendants dans la zone de décharge, et l'action de l'opérateur porte sur des paramètres globaux.

Notamment le processus de réglage des pressions est essentiellement dynamique, et résulte de l'injection à débit réglé des gaz dans l'enceinte reliée en permanence à un système de pompage. On comprend que la répartition de pression ne peut être uniforme dans l'enceinte. En outre, dans la zone de décharge, les différents éléments, supports de cible et de substrat, et la présence de la décharge apportent des perturbations locales de pression.

En conséquence, la détermination des pressions minimale et maximale qui encadre la plage de dépôt suivant l'invention revêt un caractère expérimental et ne sera valable qu'avec une enceinte de pulvérisation et des conditions de dépôt déterminées.

La détermination de ces pressions partielles minimale et maximale s'opérera de préférence, pour une enceinte déterminée et sous des conditions opératoires fixées, notamment pression totale dans l'enceinte et puissance de décharge de plasma, en sorte d'assurer une vitesse de dépôt appropriée du chrome sur le substrat, en exécutant une multiplicité de dépôts sur autant de substrats, avec des pressions partielles d'azote échelonnées, et en effectuant une analyse cristallographique des dépôts obtenus pour déterminer les pressions partielles minimale et maximale d'azote, en correspondance avec l'enceinte et les conditions opératoires fixées.

On opérera de préférence avec une pression de gaz rare comprise entre 0,1 et 0,5 Pa, et une pression partielle d'azote comprise entre 0,01 et 0,1 Pa.

Egalement on opérera de préférence avec une puissance de décharge entre 250 et 1 200 watts par $dm^2$ de cathode (cible de chrome).

Les vitesses de dépôt préférées sont comprises entre 1 et 10 nm/s.

Des caractéristiques secondaires et des avantages de l'invention ressortiront d'ailleurs de la description qui va suivre, accompagnée d'exemples.

Exemple 1. Détermination d'une gamme opératoire

On utilise un appareillage de métallisation sous vide, équipée d'une source de vapeur métallique fonctionnant en pulvérisation cathodique magnétron à courant continu, et comportant une enceinte de 30 litres $(0,03 \text{ m}^3)$.

On utilise dans la source une cathode cible de 2 $dm^2$ de surface en chrome de pureté 99,9 %. L'atmosphère dans l'enceinte était constituée d'un mélange d'argon et d'azote, sous une pression totale de 0,24 Pa.

On utilise des substrats parallélépipédiques en acier, disposés à 6 cm de la cathode, et reliés à la masse. La décharge cathodique était réglée à une puissance de 1 800 watts.

La température du substrat était de 200°C environ.

Dans ces conditions on obtenait un recouvrement de 11 μm d'épaisseur en une heure, soit une vitesse de dépot de 3 nm/s.

On a revêtu une série de substrats en faisant croître la pression partielle d'azote par échelons de 0,01 Pa depuis 0,03 Pa jusqu'à 0,09 Pa. Après dépôt, on a analysé le revêtement par diffraction de rayons X.

Pour le substrat revêtu sous 0,03 Pa, le diagramme de diffraction correspondait à un alliage monophase cubique, avec une distorsion relativement forte du réseau. C'est un diagramme typique de l'alliage selon EP-A-0 074 322.

Pour les substrats revêtus sous des pressions de 0,04 à 0,08 Pa, le diagramme correspondait à un alliage biphase, avec une phase cubique analogue à l'alliage formé sous 0,03 Pa, avec un élargissement des raies typique d'une cristallisation fine. L'autre phase était à structure quadratique, avec des paramètres de réseau entre 1,1 et 1,3.

Pour le substrat revêtu sous 0,09 Pa, le diagramme correspondait à un alliage biphase, avec une phase cubique correspondant au chrome, et une phase hexagonale correspondant au nitrure connu $Cr_2N$.

De ces résultats, on peut estimer que les pressions partielles d'azote minimale et maximale qui encadrent la formation d'un alliage biphase avec une phase chrome et une phase nitrure quadratique étaient respectivement de 0,035 et 0,085 Pa. L'analyse chimique des revêtements obtenus sous les pressions partielles d'azote 0,03, 0,04, 0,08 et 0,09 Pa, compte tenu des précisions possibles des mesures, font apparaître que les proportions d'atomes d'azote correspondant aux limites sont sensiblement 13 et 32 at %. On rappelle que les pressions partielles limites ainsi déterminées ne sont valables qu'en maintenant les conditions opératoires définies dans le cadre du présent exemple.

Exemple 2.

On opère dans les conditions opératoires définies à l'exemple 1, avec une pression partielle d'argon de 0,2 Pa et une pression partielle d'azote de 0,04 Pa.

Le revêtement analysé contient 15 at % d'azote.

La structure est biphase, avec une phase chrome à caractère microcristallin fortement accusé, et un nitrure quadratique de paramètres (absolus) de maille :

a = 285,7 pm

c = 330,6 pm

rapport 1,157

La dureté mesurée est de 2 100 Knoop.

Exemple 3.

On utilise le même appareillage que pour les exemples 1 et 2, en modifiant quelque peu les conditions opératoires.

```
Pression partielle d'argon          0,3 Pa
Pression partielle d'azote          0,06 Pa
Puissance de décharge cathodique    2 200 W
Température des substrats            350°C
Polarisation du substrat            - 100 V par
                                    rapport  à  la
                                    masse
Distance source substrat            5 cm
Durée    1 heure
```

Les analyses du revêtement obtenu donnent :

Composition : 20 at % d'azote

Structure biphase avec une phase chrome microcristalline et une phase nitrure quadratique dont les paramètres de mailles sont :

a = 280,7 pm

c = 350,4 pm

rapport 1,25

Dureté : 2 300 Knoop

Exemple 4.

On utilise une enceinte de métallisation sous vide de volume 1 m$^3$, équipée d'une cathode de 14 dm$^2$.

Les conditions de pulvérisation sont les suivantes :

```
Pression partielle d'argon          0,25 Pa
Pression partielle d'azote          0,06 Pa
Puissance de décharge cathodique    6 000 W
Température des substrats            220°C
```

Les substrats sont montés sur un carrousel tournant polarisé à - 100 V par rapport à la masse

Durée    3 heures

Les analyses des revêtements donnent :

Composition 30 at % d'azote

Structure biphase avec une phase chrome microcristalline et une phase de nitrure quadratique de paramètres :

a = 286,5 pm

c = 321,7 pm

Dureté : 1 800 Knoop

Aspect brillant (témoin de la finesse de grain)

Exemple 5.

Ces essais ont porté sur des revêtements d'épaisseur 10 µm sur une éprouvette parallélépipédique en acier. L'élément frottant antagoniste était une bague en acier rapide, le frottement étant dans l'eau, avec une vitesse de glissement de 0,55 m/s, et sous une charge de 20 da N. Le contact entre pièces frottantes était du type plan/cylindre. On a déterminé le coefficient de frottement et la vitesse d'usure.

Trois revêtements ont été essayés.

A) Un revêtement du type correspondant à l'exemple 2.

B) Un revêtement en alliage chrome-azote monophase contenant 2 % en poids d'azote, soit 7 at %, sous forme de solution solide sursaturée, avec une structure cubique centrée (chrome).

C) Un alliage chrome-azote biphase, avec une phase chrome et une phase nitrure de chrome hexagonal $Cr_2N$.

Les résultats sont les suivants :

## Tableau

|   | Vitesse d'usure | Coefficient de frottement |
|---|---|---|
| A | 0,83 nm/s | 0,32 |
| B | 4 nm/s | 0,27 |
| C | 0,83 nm/s | 0,36 |

On notera que le revêtement A, après une heure d'essai sans incident, présente dans la zone de frottement un aspect poli sans défaut.

L'essai du revêtement B a dû être interrompu avant que le frottement n'ait provoqué le percement du revêtement, ce qui aurait été obtenu en 40 minutes environ.

L'essai du revêtement C a dû être interrompu au bout de 20 minutes, des grippages localisés s'étant manifestés. Les relevés de profil et l'examen de la zone de frottement au microscope électronique à balayage ont montré des écaillages de la couche, que l'on peut attribuer à la fragilité de celle-ci.

Par ailleurs, la fragilité des couches de type C avait pu être décelée par un essai qualitatif, dit "scratch test", qui consiste à labourer avec un indenteur en diamant progressivement chargé la surface à essayer, et de relever les émissions acoustiques du labourage. Avec un revêtement de type A, il n'y a émission acoustique que lorsque l'indenteur, traversant le revêtement, attaque le substrat. Par contraste avec les revêtements de type C, l'indenteur provoque des écaillages source d'émission acoustique.

La Demanderesse a effectué de nombreux essais, qui ne peuvent être rapportés en détail ici. Ces essais ont porté notamment sur la détermination des frontières du domaine d'apparition possible du nitrure quadratique, et ont déterminé que les teneurs en azote s'étageaient depuis 13 at %, juste après la saturation de la solution solide d'insertion de l'azote dans le chrome, et qu'au-delà de 32 at % d'azote, seul le nitrure hexagonal $Cr_2N$, connu et thermodynamiquement stable, se formait. Ceci laisse à penser que le nitrure quadratique ne peut être stable que s'il est associé à du chrome.

Les essais ont montré également que le rapport a/c des paramètres de maille du nitrure quadratique ne peut être inférieur à 1,05, ni supérieur à 1,5.

Parallèlement les essais ont porté sur les conditions de dépôt. Il a été ainsi constaté que les vitesses de dépôt, mesurées en vitesse d'accroissement d'épaisseur, s'étageaient entre 1 et 10 nm/s.

En corrélation avec ces vitesses de dépôt, les puissances de décharge appropriées se situent entre 250 et 1 200 watts/dm² de cathode (ou cible). Les pressions les plus convenables sont comprises entre 0,1 et 0,5 Pa pour la pression totale et entre 0,01 et 0,1 pour la pression partielle d'azote.

Dans la pratique, des revêtements d'épaisseur inférieure à 0,1 µm sont exposés à être mis hors d'usage très rapidement ; par ailleurs, leur continuité peut être incertaine si le substrat n'est pas parfaitement poli. D'un autre côté, des revêtements d'épaisseur supérieure à 50 µm seraient généralement surabondants pour résister au frottement, alors que leur durée d'obtention serait excessivement longue. En outre de tels revêtements sont susceptibles de modifier sérieusement les cotes d'origine du substrat.

On peut ainsi admettre que fréquemment les épaisseurs se situeront entre 5 et 20 µm.

## Revendications

1. Revêtement de substrat, pour conférer à celui-ci de bonnes propriétés tribologiques, constitué d'un alliage de chrome et d'azote hors équilibre thermodynamique, caractérisé en ce que l'alliage contient, pour 100 atomes, de 87 à 68 atomes de chrome et de 13 à 32 atomes d'azote, et qu'il est constitué de deux phases, une phase de chrome microcristallin cubique contenant de l'azote inclus et une phase d'un nitrure de chrome quadratique à teneur en azote en défaut stoechiométrique par rapport au nitrure $Cr_2N$.

2. Revêtement selon la revendication 1, caractérisé en ce que le rapport des paramètres de maille du nitrure quadratique est compris entre 1,02 et 1,5.

3. Revêtement selon l'une des revendications 1 et 2, caractérisé en ce que son épaisseur est comprise entre 0,1 et 50 $\mu$m.

4. Revêtement selon la revendication 3, caractérisé en ce que son épaisseur est comprise entre 5 et 20 $\mu$m.

5. Procédé de revêtement d'un substrat électriquement conducteur, destiné à conférer à ce substrat de bonnes propriétés tribologiques, selon lequel on pulvérise du chrome en atmosphère réactive d'azote dans un gaz rare, confinée à basse pression dans une enceinte équipée d'un appareillage de pulvérisation dit magnétron avec, en combinaison avec un champ magnétique, un champ électrique établi entre le substrat anodique et une cible de chrome cathodique et engendrant un plasma, dans des conditions opératoires telles qu'il se forme un dépôt d'alliage de chrome et d'azote hors équilibre thermodynamique, procédé caractérisé en ce que l'on règle la pression partielle d'azote dans le gaz rare à une valeur choisie entre une pression minimale prédéterminée où l'alliage, monophase, est saturé en azote intersticiel, et une pression maximale prédéterminée où commence à se former du nitrure de chrome hexagonal $Cr_2N$, l'alliage contenant alors, pour 100 atomes, de 87 à 68 atomes de chrome et de 13 à 32 atomes d'azote, et présentant deux phases, une phase de chrome microcristallin cubique et une phase de nitrure de chrome quadratique, à teneur en azote en défaut stoechiométrique par rapport au nitrure de chrome hexagonal.

6. Procédé suivant la revendication 5, caractérisé en ce que, dans une enceinte déterminée, et sous des conditions opératoires fixées, notamment pression totale dans l'enceinte et puissance de la décharge de plasma, en sorte d'assurer une vitesse de dépot appropriée du chrome sur le substrat, on exécute une multiplicité de dépôts sur autant de substrats, avec des pressions partielles d'azote échelonnées, et on effectue une analyse cristallographique des dépôts obtenus pour déterminer les pressions partielles minimale et maximale d'azote, en correspondance avec l'enceinte et les conditions opératoires fixées.

7. Procédé suivant la revendication 5 ou la revendication 6, caractérisé en ce que la pression de gaz rare est comprise entre 0,1 et 0,5 pascal et la pression partielle d'azote est comprise entre 0,01 et 0,1 pascal.

8. Procédé suivant la revendication 5 ou la revendication 6, caractérisé en ce que la puissance de décharge est comprise entre 250 et 1 200 W par $dm^2$ de cathode.

9. Procédé suivant la revendication 5 ou la revendication 6, caractérisé en ce que la vitesse de croissance de dépôt est comprise entre 1 et 10 nm/s.

## Patentansprüche

1. Beschichtung bestehend aus einer nicht im thermodynamischen Gleichgewicht befindlichen Chrom-Stickstoff-Legierung zum Verleihen guter tribologischer Eigenschaften an ein Substrat, dadurch gekennzeichnet, daß die Legierung pro 100 Atome von 87 bis 68 Chromatome und von 13 bis 32 Stickstoffatome enthält, und daß sie aus zwei Phasen besteht, wobei eine Phase aus mikrokristallinem kubischen Chrom, welches Stickstoff inkludiert enthält, und eine Phase aus einem quadratischen Chromnitrid mit einem unterstöchiometrischen Gehalt an Stickstoff in bezug auf $Cr_2N$ besteht.

2. Beschichtung nach Anspruch 1, dadurch gekennzeichnet, daß das Verhältnis der Gitterparameter des quadratischen Nitrids zwischen 1,02 und 1,5 liegt.

3. Beschichtung nach einem der Ansprüche 1 und 2, dadurch gekennzeichnet, daß ihre Dicke zwischen 0,1

und 50 μm beträgt.

4. Beschichtung nach Anspruch 3, dadurch gekennzeichnet, daß ihre Dicke zwischen 5 und 20 μm beträgt.

5. Verfahren zum Beschichten eines elektrisch leitfähigen Substrats, welches dazu bestimmt ist, dem Substrat gute tribologische Eigenschaften zu verleihen, gemäß welchem Chrom in einer Atmosphäre aus reaktivem Stickstoff in einem Edelgas pulverisiert wird, welches mit geringem Druck in einem Behälter enthalten ist, welcher Behälter mit einer Pulverisierungsapparatur, Magnetron genannt, mit einem elektrischen Feld, in Verbindung mit einem Magnetfeld, welches elektrische Feld zwischen dem anodischen Substrat und einer Zielscheibe aus kathodischem Chrom angelegt wird und ein Plasma erzeugt, ausgestattet ist unter Arbeitsbedingungen, bei welchen sich eine Abscheidung von einer nicht im thermodynamischen Gleichgewicht befindlichen Chrom-Stickstoff-Legierung bildet, welches Verfahren dadurch gekennzeichnet ist, daß der Partialdruck des Stickstoff in dem Edelgas zwischen einem vorbestimmten Minimaldruck, bei welchem die einphasige Legierung an die Zwischenräume füllendem Stickstoff gesättigt ist, und einem vorbestimmten Maximaldruck, bei welchem sich hexagonales Chromnitrid $Cr_2N$ zu bilden beginnt, geregelt wird, wobei die Legierung dann pro 100 Atome von 87 bis 68 Chromatome und von 13 bis 32 Stickstoffatome enthält und aus zwei Phasen besteht, wobei eine Phase aus mikrokristallinem kubischen Chrom und eine Phase aus einem quadratischen Chromnitrid mit einem unterstöchiometrischen Gehalt an Stickstoff in bezug auf hexagonales Chromnitrid besteht.

6. Verfahren nach Anspruch 5, dadurch gekennzeichnet, daß man in einem bestimmten Behälter und unter festgelegten Arbeitsbedingungen, insbesondere dem Gesamtdruck in dem Behälter und der Entladestärke des Plasmas, um eine geeignete Abscheidegeschwindigkeit des Chroms auf dem Substrat sicherzustellen, eine Mehrzahl von Abscheidungen auf ebenso vielen Substraten mit abgestuften Stickstoff-Partialdrücken ausführt und eine kristallographische Analyse der erhaltenen Abscheidungen durchführt, um die minimalen und maximalen Stickstoff-Partialdrücke in Übereinstimmung mit dem Behälter und den festgelegten Arbeitsbedingungen zu bestimmen.

7. Verfahren nach Anspruch 5 oder 6, dadurch gekennzeichnet, daß der Druck des Edelgases zwischen 0,1 und 0,5 Pascal und der Stickstoff-Partialdruck zwischen 0,01 und 0,1 Pascal liegt.

8. Verfahren nach Anspruch 5 oder 6, dadurch gekennzeichnet, daß die Entladestärke zwischen 250 und 1200 W pro dm² der Kathode liegt.

9. Verfahren nach Anspruch 5 oder 6, dadurch gekennzeichnet, daß die Wachstumsgeschwindigkeit der Abscheidung zwischen 1 und 10 nm/s liegt.


**Claims**

1. Coating on a substrate for conferring good tribological properties on it, consisting of a non thermodynamic equilibrium alloy of chromium and nitrogen, characterised in that the alloy contains, per 100 atoms, from 87 to 68 atoms of chromium and from 13 to 32 atoms of nitrogen, and in that it consists of two phases, a cubic microcrystalline chromium phase containing included nitrogen and a quadratic chromium nitride phase with a nitrogen content which is stoichiometrically deficient relative to the $Cr_2N$ nitride.

2. Coating according to Claim 1, characterised in that the ratio of the quadratic nitride lattice parameters is between 1.02 and 1.5.

3. Coating according to Claims 1 and 2, characterised in that its thickness is between 0.1 and 50 μm.

4. Coating according to Claim 3, characterised in that its thickness is between 5 and 20 μm.

5. Method of coating an electrically conductive substrate, intended to confer good tribological properties on this substrate, according to which chromium is sputtered in a reactive atmosphere of nitrogen in a rare gas confined at low pressure in a chamber equipped with so-called magnetron sputtering equipment with, in combination with a magnetic field, an electric field established between the anode substrate and a cathode chromium target and generating a plasma under operating conditions such that a deposit of a non thermodynamic equilibrium alloy of chromium and nitrogen is formed, a method characterised in that the nitrogen partial pressure in the rare gas is set to a value between a predetermined minimum pressure at which the single-phase alloy is saturated with included nitrogen and a predetermined maximum pressure at which hexagonal chromium nitride $Cr_2N$ begins to form, the alloy then containing, per 100 atoms, from 87 to 68 atoms of chromium and from 13 to 32 atoms of nitrogen and having two phases, a cubic microcrystalline chromium phase and a quadratic chromium nitride phase with a nitrogen content which is stoichiometrically deficient relative to the hexagonal chromium nitride.

6. Method according to Claim 5, characterised in that, in a given chamber and under given operating conditions, in particular the total pressure in the chamber and the plasma discharge power, such as to obtain an appropriate rate of deposition of the chromium onto the substrate, a multiplicity of depositions are executed onto a number of substrates with staggered nitrogen partial pressures, and a crystallographic analysis of the deposits obtained is carried out to determine the minimum and maximum nitrogen partial pressures for the given chamber and operating conditions.

7. Method according to Claim 5 or Claim 6, characterised in that the rare gas pressure is between 0.1 and 0.5 pascals and the nitrogen partial pressure is between 0.01 and 0.1 pascals.

8. Method according to Claim 5 or Claim 6, characterised in that the discharge power is between 250 and 1200 $W/dm^2$ of cathode.

9. Method according to Claim 5 or Claim 6, characterised in that the rate of increase in the deposit is between 1 and 10 nm/s.